# EUROPÄISCHE PATENTANMELDUNG

(11) **EP 1 028 608 A2**
(43) Veröffentlichungstag der Anmeldung: **16.08.2000**
(21) Anmeldenummer: 00102724.2
(22) Anmeldetag: 10.02.2000
(51) Int. Cl.: H05K 3/28, H05K 1/02, H05K 7/20

(54) **Verfahren und Beschichtungsmasse für die Applikation von Heatsinkpaste auf Leiterplatten**

(30) Priorität: 12.02.1999 DE 19905869
(71) Anmelder: Peters Research GmbH + Co. KG, 47906 Kempen (DE)
(72) Erfinder: Peters, Werner Dipl.Ing, D-47906 Kempen (DE); Kramer, Sven, Dipl-Ing., D-47647 Kerken (DE); Suppa, Manfred, Dr., D-44803 Bochum (DE); Kollasa, Michael, D-47441 Moers (DE)
(74) Vertreter: Funken, Josef, Dipl.-Ing.

(57) **Zusammenfassung**

Masse für die Beschichtung von Leiterplatten, wobei die Masse als druckfähige Heatsinkpaste mit selbstverlöschenden Eigenschaften zur Erzeugung von lötbeständigen, dielektrischen, nicht korrosiven, definierten Wärmesenken vorliegt. Die Masse hat eine Wärmeleitfähigkeit von mindestens 0,5 W/mK und vor dem Aushärten eine dynamische Viskosität η von mindestens 10 Pas.

Die Erfindung umfaßt ferner Leiterplatten, welche mit der genannten Masse (10) beschichtet sind, wobei sich die Beschichtungsmasse (10) insbesondere ohne Zwischenschaltung von Metallschichten direkt auf dem Isolierstoffkörper (6) befindet und als Wärmesenke dient.

Ferner gehört zur Erfindung ein Verfahren, bei welchem die Isolierstoffplatte (6) von Leiterplatten mit dem wärmeleitenden Masse (10) bedruckt wird, um eine Wärmesenke herzustellen. Das Drucken kann insbesondere im Siebdruck- oder Schablonendruckverfahren erfolgen.

## Beschreibung

Die vorliegende Erfindung betrifft eine Bindemittel enthaltende Masse nach dem Oberbegriff von Anspruch 1, Leiterplatten nach dem Oberbegriff von Anspruch 22 sowie ein Verfahren zur Herstellung von Leiterplatten nach dem Oberbegriff von Anspruch 30.

Leiterplatten, auch "gedruckte Schaltungen" genannt, bestehen in der Regel aus einer Isolierstoffplatte, welche aus glasfaserverstärktem Epoxidharz oder phenolharzgetränktem Hartpapier hergestellt sein kann. Auf dieser Isolierstoffplatte sind elektrische Leiter angeordnet, welche die später auf der Platte aufzubringenden elektrischen Bauteile (z.B. Widerstände, Kondensatoren, Spulen, Transistoren, ICs) gemäß einem vorgegebenen Schaltungsplan verbinden. Zur Bestückung der Leiterplatte mit den genannten Bauteilen sind ferner in der Regel metallisierte und mit den Leitern elektrisch leitend verbundene Bohrlöcher in der Platte angebracht, in welche die Bauteile mit entsprechenden Füßen bzw. Pins gesteckt werden können, oder es sind entsprechende Lande-/ Anschlußflächen für oberflächenmontierbare Bauteile vorgesehen.

Die Aufbringung der Leiter auf den Isolierstoffkörper kann dabei z.B. so geschehen, daß zunächst der Isolierstoffkörper metallisiert wird (vorzugsweise mit Kupfer) und daß hierauf mit einem Ätzresistlack die herzustellende Schaltung gedruckt wird. In einem nächsten Schritt wird die Metallbeschichtung an den nicht mit dem Lack geschützten Stellen weggeätzt, so daß nur die gewünschten Leiter übrigbleiben. Der derart oder auf andere Weise mit Leitern und ggf. Bohrlöchern versehene Isolierstoffkörper stellt die Leiterplatte (Platine) dar, welche anschließend mit den elektrischen Bauteilen bestückt werden kann. Zur Befestigung und Herstellung des notwendigen elektrischen Kontaktes untereinander und zu den Leitern werden die Bauteile dabei in der Regel verlötet.

Es hat sich gezeigt, daß die Bestückungsdichte der elektrischen Bauteile auf den Leiterplatten immer mehr zunimmt, da immer komplexere Schaltungen auf immer kleinerem Raum (Miniaturisierung) unterzubringen sind. Hierdurch und durch den Einsatz von Leistungsbauelementen, die teilweise eine hohe Verlustleistung in Form von Wärme erzeugen, ist eine gezielte Abführung der entstehenden Verlustwärme vom Entstehungsort und deren Abgabe an die Umgebung notwendig. Andernfalls würde es zu einer Überhitzung von Bauteilen kommen, welche Fehlfunktionen und im Extremfall auch eine Zerstörung des Bauteils zur Folge hätte. Bei verschiedenen Anwendungen kommt erschwerend hinzu, daß am Einsatzort der Leiterplatte bereits erhöhte Temperaturen herrschen. Dies ist z.B. in Kraftfahrzeugen bei Leiterplatten für die Motorsteuerung der Fall.

Um die genannte Wärmeabfuhr von den Wärmequellen auf der Leiterplatte zu erreichen, werden nach dem Stand der Technik sogenannte "Wärmesenken" angeordnet, für die sich der englische Ausdruck "Heatsinks" eingebürgert hat. Es handelt sich hierbei um metallische Kühlkörper, welche einerseits durch die gute Wärmeleitung von Metallen für einen Abfluß der Wärme vom Entstehungsort sorgen und andererseits durch eine große Oberfläche zur Umgebungsluft hin die Abgabe der Verlustwärme an die Umgebung ermöglichen. Für zweiseitig bestückte Leiterplatten, wie sie z.B. für Motorsteuerungen eingesetzt werden, hat sich eine ähnliche Technik entwickelt. Hierbei werden über durchgehende, metallisierte und ggf. mit einem weiteren Metall versehene Bohrungen die Wärmequellen auf der Vorderseite der Leiterplatte mit einer mehr oder weniger großflächigen Wärmesenke auf der Rückseite der Leiterplatte verbunden. Eine solche Wärmesenke besteht dabei im wesentlichen aus einer Metallfolie (z.B. aus Kupfer, Aluminium), welche auf der Rückseite der Leiterplatte fixiert sein kann. Die Fixierung geschieht z.B. durch Kleben, Vernieten oder Verschrauben. Die Fähigkeit zur Wärmeableitung des Übergangs von der genannten Wärmesenke zur Metallisierung des Bohrloches, bei welcher die Verlustwärme der Vorderseite der Leiterplatte "ankommt", wird dabei durch die (Klebe-) Folie zwischen der rückseitigen Wärmesenke und der Metallkaschierung und durch die jeweiligen spezifischen Wärmeübergangswiderstände zwischen Leiterplatte und Klebefolie sowie Klebefolie und "Heatsink" reduziert. Die beschriebene Technik zur Anbringung von zu verklebenden "Heatsinks" hat zudem den Nachteil, daß sie ein sehr arbeits- und damit kostenintensives Verfahren darstellt. So müssen zunächst die als "Heatsink" dienenden Metallfolien in entsprechenden Formen gestanzt werden, was die Herstellung und den Betrieb von entsprechenden Stanzwerkzeugen erfordert. Sodann muß eine doppelseitige Klebefolie auf die ausgestanzten "Heatsinks" aufgebracht werden und diese müssen auf der Leiterplatte aufgeklebt werden. Die Metallfolie muß anschließend noch mit entsprechenden Lacksystemen zur elektrischen Isolierung und zum Schutz vor Korrosion beschichtet werden, wobei definierte Lackschichtdicken mit entsprechenden elektrischen und dielektrischen Eigenschaften erforderlich sind. Da diese Heatsinks üblicherweise mehrere 100 µm hoch sind, ist eine ausreichende Kanten- bzw. Flankenabdeckung nicht prozeßsicher zu realisieren. Die genannten Arbeitsschritte lassen sich in der Regel nicht automatisieren und müssen daher von Hand durchgeführt werden. Sie stellen daher einen erheblichen Zeit- und Personalaufwand dar, und das erhaltene Ergebnis erreicht nicht die geforderte Präzision einer maschinellen Fertigung.

In der GB 2 229 041 A wird ein spezielles Wärmeübertragungsmaterial vorgeschlagen, welches zwischen der oben beschriebenen als Wärmesenke dienenden Metallfolie und einer Leiterplatte anzuordnen ist. Dieses Material besteht aus einem Flüssigharz, das Metalloxide enthält (metaloxid filled fluid resin) und an der Umgebungsluft aushärtet. Durch Bedrucken von Metallfolien z.B. aus Aluminium mit diesem Material wird eine Wärmesenke hergestellt, welche bereits einseitig mit einer Wärmeübertragungsschicht versehen ist. Die GB 2 229 041 A beschreibt nicht, wie eine derart vorbeschichtete Metallfolie auf der Leiterplatte fixiert wird. Sofern hierfür die bekannten Techniken wie Verkleben, Vernieten oder Verschrauben verwendet werden, ist der erzielte Vorteil sehr gering. Die GB 2 229 041 A erwähnt ferner, daß das offenbarte Material in Ausnahmefällen direkt auf freiliegende Kupferflächen auf der Leiterplatte gedruckt werden kann, wenn diese selbst bereits die Wärmesenke darstellen.

Zur Förderung der Wärmeableitung von Leiterplatten ist es im Stand der Technik ferner bekannt, sogenannte Wärmeleitpasten zu verwenden. Diese sind jedoch nicht lötstabil, d.h., sie halten die üblichen Löt-Temperaturen beim Verlöten der elektrischen Bauteile nicht aus. Die Wärmeleitpasten werden daher häufig nach der Bestückung der Leiterplatte mit den Bauteilen aufgebracht, was jedoch nicht mit rationellen Druckverfahren wie Siebdruck oder Schablonendruck möglich ist. Durch Drucken vor der Bauteilbestückung können die Wärmeleitpasten nur dann aufgebracht werden, wenn ein Kontakt der Wärmeleitpaste mit Lot streng vermieden wird. Beim Wellenlöten kann daher nur die Leiterplattenseite ohne Wärmeleitpaste gelötet werden, und auf Reflowlötverfahren muß ganz verzichtet werden, wenn nicht die mit Wärmeleitpaste beschichteten Flächen kosten- und verfahrensintensiv mit z.B. Lötabdecklacken geschützt worden sind.

Die vorliegende Erfindung hat sich gegenüber dem Stand der Technik die Aufgabe gestellt, die geschilderten Nachteile zu vermeiden und ein Material für eine Wärmesenke, ein Verfahren zur Herstellung von Leiterplatten sowie Leiterplatten selbst zur Verfügung zu stellen, welche in einem vereinfachten Verfahren - insbesondere automatisiert - angewendet bzw. hergestellt werden können. Zusätzlich soll die resultierende Leiterplatte dabei verbesserte Eigenschaften haben, und zwar insbesondere in bezug auf die erzielte Wärmeabfuhr, die dielektrischen Eigenschaften, das Gewicht der Leiterplatte und eine erhöhte Funktionssicherheit bezüglich der Korrosion und Kurzschlußgefahr ausgehend vom "Heatsink".

Diese Aufgabe wird durch eine Bindemittel enthaltende Masse nach Anspruch 1, durch eine Leiterplatte nach Anspruch 18 sowie durch ein Verfahren zur Herstellung von Leiterplatten nach Anspruch 26 gelöst. Vorteilhafte Ausgestaltungen der genannten Gegenstände sind in den entsprechenden Unteransprüchen enthalten.

Die erfindungsmäßige Masse (Sieb- oder Schablonendruckmasse) enthält als Bindemittel Polymere, die insbesondere für die Beschichtung von Leiterplatten geeignet sind. Die Masse hat im ausgehärteten Zustand eine Wärmeleitfähigkeit λ von mindestens 0,5 W/mK. Sie ist dadurch gekennzeichnet, daß sie vor dem Aushärten eine dynamische Viskosität η von mindestens 10 Pas hat mit einer für die Verarbeitung notwendigen Thixotropie.

Mit einer Masse der genannten Eigenschaften lassen sich überraschenderweise die in der Aufgabenstellung angestrebten Ziele erreichen. Durch ihre Wärmeleitfähigkeit von mindestens 0,5 W/mK kann diese Masse nämlich als Wärmesenke dienen, d.h., sie kann Wärme von einer Wärmequelle weiterleiten und durch z.B. eine große Oberfläche an die Umgebung abgeben. Diese Fähigkeit steigt natürlich mit wachsender Wärmeleitfähigkeit, wobei Werte von 0,5 bis 5 W/mK bevorzugt sind. Andererseits kann die Masse durch die dynamische Viskosität η von mindestens 10 Pas vor dem Aushärten drucktechnisch gut verarbeitet werden. Insbesondere kann sie im Siebdruck- oder Schablonendruckverfahren auf eine Leiterplatte in entsprechenden Formen gedruckt werden, wobei die gewünschte Form sauber und mit scharfen Grenzen bzw. Flanken erzielbar ist. Dies erlaubt es, auf die aus dem Stand der Technik bekannte Metallfolie als Wärmesenke ganz zu verzichten und allein eine entsprechende Schicht der erfindungsgemäßen Masse als Wärmesenke zu verwenden. Wichtig ist hierbei auch, daß die erfindungsgemäße Masse in einem weiten Schichtdickenbereich aufgebracht werden kann.

Die erfindungsgemäße Masse ist vorzugsweise siebdruck- und/oder schablonendruckfähig. Siebdruck und Schablonendruck stellen die gängigsten und rationellsten Techniken zum Bedrucken von Leiterplatten dar. Es ist daher von besonderem Vorteil, wenn die erfindungsgemäße Masse mit diesen Verfahren gedruckt werden kann. Daneben sind auch Tampon-Druck, Dispensen sowie selektive Beschichtungsverfahren, wie sie bei der Verarbeitung von conformal coatings (Schutzlacken) gebräuchlich sind (z.B. Nordson-Selectcoat®, Amherst, Ohio 44001-2422, USA).

Es wird nach der Application eine lunkerfreie Beschichtung erzielt.

Entsprechend der gewählten Application ist auch ein komplettes oder partielles Umhüllen von wärmeerzeugenden Komponenten möglich.

Auch eine mechanische Fixierung und thermische Anbindung von Kühlkörpern auf einer Leiterplatte ist möglich.

Weiterhin ist die erfindungsgemäße Masse vorzugsweise lötbadbeständig. Die Lötbadbeständigkeit wird nach üblichen Prüfmethoden festgestellt, insbesondere der IPC-SM 840-C, 4.8.9.2. Die Lötbadbeständigkeit bedeutet typischerweise eine Beständigkeit eines Lackes gegen Löttemperaturen von 265°C für mindestens 20 s oder nach MIL P 55 110 C eine Beständigkeit gegen Löttemperaturen von 288 °C für mindestens 10 s.

Die lötbadbeständige Masse wird ferner vorzugsweise so eingestellt, daß keine Lotanhaftungen ihr verbleiben und eine ausreichende Haftung zum Substrat verbleibt. Allen bislang verfügbaren Wärmeübertragungsmaterialien (z.B. Wärmeleitpasten) ist gemein, daß diese Systeme nicht als lötstabil eingestuft werden bzw. sind und neben auftretenden Schäden unkontrollierte Lotanhaftungen (z.B. Lotperlen, Lotspinnen) festzustellen sind.

Darüber hinaus zeigt die erfindungsgemäße Masse eine ausreichende Haftung auf allen üblicherweise in der Leiterplattenfertigung und Elektronik eingesetzten Substraten (z.B. glasfaserverstärktes Epoxidmaterial, Phenolharz gehärtetes Papier, Lötstopplacke und verschiedene metallische Untergründe wie z.B. Gold, Zinn, Blei, Nickel, Palladium, Silber, Kupfer). Die Haftung der erfindungsgemäßen Masse ist z.B. auf verschiedensten Lötstopplacken so gut, daß bei einer Haftungsprüfung kein Adhäsionsbruch an der Grenzfläche Lötstopplack/erfindungsgemäße Masse festzustellen ist, sondern ein Adhäsionsbruch an der Grenzfläche Substrat/Lötstopplack oder Kohäsionsbruch Lötstopplack festzustellen ist.

Ferner ist die erfindungsgemäße Masse vorteilhafterweise selbstverlöschend. Für die Selbstverlöschung gibt es ebenfalls übliche Prüfmethoden, z.B. die Underwriters Laboratories Spezifikation UL 94 VO. Durch das selbstverlöschende Verhalten der Masse wird deren Einsatzbereich erheblich erweitert und umfasst auch sicherheitskritische Anwendungen unter hoher Temperaturbelastung bzw. Brandgefahr.

Hinsichtlich ihrer elektrischen Eigenschaften hat die erfindungsgemäße Masse vorzugsweise einen Oberflächenwiderstand von ca. 10¹⁴ bis 10¹⁶ Ω (bestimmt gemäß VDE 0303, Teil 3), einen Durchgangswiderstand von ca. 10¹⁴ bis 10¹⁶ Ω cm (bestimmt gemäß VDE 0303, Teil 3), eine Durchschlagfestigkeit von mehr als 10 kV/mm (bestimmt gemäß VDE 0303, Teil 2) und/oder eine Kriechstromfestigkeit von mehr als 350 (bestimmt gemäß IEC 112, in Verbindung mit VDE 0109, Teil 11 auf Basismaterial mit CTI 250). Die genannten Werte machen die Masse insbesondere geeignet für die Anwendungen auf Leiterplatten, wo elektrische Felder auftreten und die elektrischen wie dielektrischen Eigenschaften daher eine Rolle für die Funktion der aufgebrachten Schaltung spielen können. Mit den genannten Werten wird erreicht, daß eine störende Beeinflussung der Schaltung durch die erfindungsgemäße Masse nicht auftritt.

Die ausgehärtete Masse ist vorzugsweise dauerbeständig bei Temperaturen von über 100 °C, besonders bevorzugt bis 155 °C. Die Masse liegt somit in der Isolierstoffklasse F gemäß VDE 0530, Teil 1. Eine derart hohe Temperaturbeständigkeit macht die Masse geeignet für viele Anwendungen unter Extrembedingungen. Solche treten z.B. in Kraftfahrzeugen auf, wo Leiterplatten im Motorbereich für die Motorsteuerung eingesetzt werden. Hervorzuheben ist auch, daß durch zerstörende mechanische Einflüsse die elektrischen Parameter erhalten bleiben und nicht wie beim Metallheatsink zu unkontrollierten Fehlströmen führen können.

Nach der Aushärtung, vorzugsweise bei großflächiger Application, ist die Neigung zur Verwindung und Verwölbung der Leiterplatte minimiert.

Das Bindemittel, welches die erfindungsgemäße Masse zur Filmbildung enthält, kann allen derzeit bekannten Systemen entnommen werden, sofern die erfindungsgemäßen Eigenschaften hiermit erzielbar sind. Insbesondere kann es sich bei dem Bindemittel um ein Naturharz-, Chlorkautschuk-, Epoxy-, Polyester-, Polyacryl-, Amino-harz-, Phenolharz-, Polyvinyl-, Silikon-, Silikonkautschuk-, Polyurethan- oder Polyharnstoffsystem handeln.

Das Bindemittel kann auch ein acrylgruppenhaltiges UV-härtendes System und/oder ein anorganisches Bindemittelsystem, insbesondere Silicat, sein. Selbstverständlich ist es im Rahmen der Erfindung auch möglich, zwei oder mehr der oben genannten Systeme chemisch oder physikalisch miteinander zu einem Gemisch zu kombinieren.

Nach einer besonderen Ausgestaltung der Erfindung besteht die Masse aus einer Harzmatrix mit einer oder mehreren feinverteilten (dispergierten) Substanzen, die eine Wärmeleitfähigkeit λ von mindestens 0,5 W/mK besitzen. Vorzugsweise liegen die Substanzen in Form von Feststoffpartikeln vor. Durch die Kombination der Harzmatrix mit feinverteilten Substanzen, die eine höhere Wärmeleitfähigkeit als die Matrix haben, ist es möglich, die gesamte (d.h. mittlere) Wärmeleitfähigkeit der resultierenden Masse auf den erfindungsgemäßen Wert von mindestens 0,5 W/mK nach Belieben einzustellen. Die Wärmeleitfähigkeit des Harzes selbst kann dabei geringer als 0,5 W/mK sein und muß nicht durch Veränderungen am Harz selbst auf einen bestimmten Wert eingestellt werden. Die gewünschte Gesamtwärmeleitfähigkeit wird vielmehr durch die Auswahl, Kombination und einen entsprechend hohen Mengenanteil des feinverteilten Materials erzielt.

Vorzugsweise enthält die Harzmatrix feinverteilte Feststoffpartikel, deren Teilchengrößenverteilung mindestens zwei Maxima besitzt. Üblicherweise besitzen aus einem bestimmten Herstellungsprozess stammende Feststoffpartikel eine Teilchengrößenverteilung mit genau einem Maximum, dessen Lage von der Art des Prozesses und den eingestellten Prozessparametern abhängt. Es hat sich nun überraschenderweise gezeigt, daß die angestrebten Eigenschaften der erfindungsgemäßen Masse sich verbessern lassen, wenn Feststoffpartikel mit mindestens zwei Maxima in der Teilchengrößenverteilung eingesetzt werden. Diese erhält man z.B. durch die Kombination von Partikeln aus zwei unterschiedlichen Herstellungsprozessen. Insbesondere kann auf diese Art und Weise die Wärmeleitfähigkeit der Masse erheblich erhöht werden.

Weiterhin kann eine Verbesserung (insbesondere der Wärmeleitfähigkeit) erzielt werden, wenn die feinverteilten Feststoffpartikel unterschiedliche Teilchenformen besitzen, z.B. in etwa sphärische Teilchen kombiniert mit dendritischen und/oder faserförmigen und/oder lamellaren Teilchen. Auch hier kann man entsprechende Teilchenmixe erhalten, indem man Feststoffpartikel aus unterschiedlichen Herstellungsprozessen verwendet.

Vorzugsweise bestehen die feinverteilten Substanzen aus Feststoffpartikeln mit einer Größe von 1 µm bis 150 µm.

Die Feststoffpartikel können dabei insbesondere aus Metallen, vorzugsweise Kupfer, Aluminium, Eisen, eutektischen Mischungen, Legierungen, sowie Metalloxiden bestehen. Insbesondere ist es möglich, daß die Feststoffpartikel aus einem Metallkern mit einem elektrisch isolierenden Überzug bestehen, wobei der Überzug insbesondere ein Oxid des entsprechenden Metalls sein kann. Ein derartiger Aufbau aus einem Metallkern und einem (Oxid-) Überzug hat den Vorteil, daß der Kern des Partikels hohe Wärmeleitfähigkeit des Metalls zur Verfügung stellt, während der Überzug für eine elektrische Isolierung sorgt.

Auch bei einer sehr hohen Dichte der Füllpartikel, bei welcher die einzelnen Partikel zueinander in Kontakt stehen, wird somit gewährleistet, daß keine durchgehende elektrische Leitfähigkeit der Masse entsteht. Der Übergang von Partikel zu Partikel wird immer durch die zwischenliegenden (Oxid-) Überzüge elektrisch unterbrochen.

Die gut wärmeleitenden Feststoffpartikel können auch aus Keramik bestehen, vorzugsweise aus Nitriden, Karbiden, Boriden, Siliciden oder Silicaten oder deren Abmischungen. Keramiken haben den Vorteil, daß sie leichter sind als Metalle, elektrisch nichtleitend und die Druckeigenschaften positiv beeinflussen. Ebenso können die Feststoffpartikel aus geeigneten Polymeren bestehen, und zwar insbesondere auf Basis von Polyaromaten, als auch auf Basis von natürlichen oder synthetischen Mineralien, wie z.B. Bariumsulfaten, Magnesium- und/oder Aluminiumsilikaten. Die Auswahl der Feststoffpartikel zeichnet sich vorzugsweise dadurch aus, daß Feststoffe unterschiedlicher Kornverteilungen und Teilchenform eingesetzt werden.

Die erfindungsgemäße Masse kann weiterhin in der verarbeitungsfähigen Form Lösemittel enthalten. Dabei kann es sich um organische Lösemittel handeln, aus ökologischen Gründen wird jedoch zunehmend Wasser als Lösemittel bevorzugt. Mit einem hohen Festkörpergehalt von bis zu 100 % kann erreicht werden, daß sich die Schichtdicke des aufgedruckten Lackes durch das Trocknen, d.h. das Verdunsten der Lösemittel und das Vernetzen der Bindemittel, nicht mehr oder nur unwesentlich ändert.

Weiterhin kann die Masse bekannte Formulierungshilfsstoffe enthalten, welche der gezielten Applikationseinstellung dienen, und zwar insbesondere in bezug auf die Dispergierung, Entgasung, das Fließverhalten, das Trocknungsverhalten, die Verlaufseigenschaften und die Oberflächenbeschaffenheit.

Ferner kann die Masse auch in bekannter Weise organische oder anorganische nicht lösliche, lösliche oder schwer lösliche farbgebende Substanzen enthalten, wodurch eine gewünschte Färbung der Masse eingestellt wird. Durch die Variation der Farbgebung (weißschwarz) kann die Masse in ihrem Wärmestrahlungsverhalten beeinflußt werden (weiß ist wegen geringer Absorption und gleich guter Emission gut bei heller Sonneneinstrahlung). Schließlich kann die Masse auch in bekannter Weise funktionale Füllstoffe enthalten, die neben Haftung und Fließverhalten eine Rezepturkostenbeeinflussung erlauben.

Eine bevorzugte Rezeptur der erfindungsgemäßen Masse sieht folgendermaßen aus:
- 10 - 40: Gewichtsteile Bindemittel
- 20 - 80: Gewichtsteile wärmeleitende Feststoffe und ggf. farbgebende - vorzugsweise anorganische oder organische, lösliche oder schwer lösliche - Substanzen, und/oder Füllstoffe,
- 0 - 30: Gewichtsteile Formulierungshilfsstoffe und/oder Lösemittel.

Weitere geeignete Rezepturen sind in den Beispielen enthalten.

Die erfindungsgemäße Masse kann schließlich für die Verarbeitung als 1-Komponenten- oder 2-Komponenten- (bzw. Mehrkomponenten-) System hergestellt sein. Bei 2-K-Systemen werden typischerweise ein Bindemittel und ein Härter als zwei getrennte Komponenten hergestellt, welche erst kurz vor der Verarbeitung in einem entsprechenden Gewichtsverhältnis zu mischen sind. Die daraufhin einsetzenden Reaktionen führen zu einer Aushärtung der Mischung. Im Gegensatz dazu werden 1-K Systeme durch andere Mechanismen ausgehärtet, insbesondere durch Kontakt mit Luft bzw. Sauerstoff, durch thermische Erwärmung oder durch UV-Bestrahlung.

Zur vorliegenden Erfindung gehört auch eine Leiterplatte, welche in bekannter Weise eine Isolierstoffplatte als Grundkörper hat, auf welcher Leiter und/oder Bohrungen und/oder entsprechende Lande-/Anschlußflächen für oberflächenmontierbare Bauteile zur Bestückung mit elektronischen Bauteilen angebracht sind.

Diese Leiterplatte ist dadurch gekennzeichnet, daß zumindest auf Teilen der Oberfläche der Isolierstoffplatte und/oder in mindestens einer Bohrung der Leiterplatte eine nicht-metallische Beschichtungsmasse angeordnet ist, wobei die Masse im ausgehärteten Zustand eine Wärmeleitfähigkeit λ von mindestens 0,5 W/mK hat. Hierdurch kann die Wärmekontaktfläche erhöht werden. Die erfindungsgemäße Leiterplatte ist demnach dadurch charakterisiert, daß sie u.a. unmittelbar auf der Oberfläche der Isolierstoffplatte eine Beschichtung mit einer guten Wärmeleitfähigkeit hat.

Diese Beschichtung kann daher selbst als Wärmesenke dienen, d.h. an den Bauteilen entstehende Verlustwärme ableiten und großflächig an die Umgebung abgeben. Wichtig ist hierbei, daß sich die Beschichtung zumindest teilweise direkt auf der Oberfläche der Isolierstoffplatte befindet. Bei der genannten Leiterplatte ist es demnach nicht nötig, großflächige Metallfolien vorzusehen, welche als Wärmesenke dienen, deren Anwendung und Verarbeitung jedoch mit den oben geschilderten Nachteilen verbunden sind. Vielmehr kann die Wärmesenke direkt maschinell erzeugt, d.h. insbesondere aufgedruckt werden.

Als weiterer Vorteil der erfindungsgemäßen Leiterplatte stellt sich dabei eine Gewichtsersparnis heraus, da durch die Beschichtung das hohe Gewicht von Metallfolien vermieden werden kann. Sofern sich bei der Leiterplatte die Beschichtung auch in einer Bohrung befindet, sorgt sie auch dort für einen optimalen Wärmeübergang. Beim Stand der Technik werden nämlich Bohrungen, die der Wärmeweiterleitung von einer Frontseite der Leiterplatte zur Rückseite dienen und mit Metallfolie kaschiert sind, nicht mit Material ausgefüllt. Statt dessen wird die als "Heatsink" dienende Metallfolie bzw. das zwischen dieser Folie und der Leiterplatte liegende Doppelklebeband flach über die Bohrung gelegt, ohne daß sie in die Bohrung eindringen oder diese gar ausfüllen.

Demgegenüber wird bei der vorliegenden Erfindung das Bohrloch ganz oder zumindest teilweise mit der Beschichtung ausgefüllt, so daß eine massive Wärmebrücke zur Frontseite gebildet wird und ein intensiver und großflächiger Kontakt zur gegebenenfalls vorhandenen auskleidenden Metallfolie entsteht, die die üblicherweise vorhandenen Wärmeübergangswiderstände drastisch reduziert.

Vorzugsweise wird bei der erfindungsgemäßen Leiterplatte zwischen einer Teilfläche der Beschichtungsmasse und der Isolierstoffplatte mindestens eine Metallschicht angeordnet. Hierdurch wird erreicht, daß die vorteilhaften Eigenschaften von Metallbeschichtungen, d.h. insbesondere ihre sehr hohe Wärmeleitfähigkeit, zumindest bereichsweise ausgenutzt werden können. Dies ist insbesondere für die Ableitung der Wärme unmittelbar vom Entstehungsort und für ihre Weiterleitung auf die Rückseite einer Leiterplatte sinnvoll. Die eigentliche großflächige Weitergabe der Wärme an die Umgebung kann dann jedoch durch die Beschichtung erfolgen.

In diesem Zusammenhang sei darauf hingewiesen, daß zur Erfindung auch solche Leiterplatten gehören, bei welchen sich zwischen der gesamten wärmeleitfähigen Beschichtung und der Isolierstoffplatte gegebenenfalls noch andere Materialien befinden, sofern es sich hierbei nicht ganzflächig um Metalle handelt. Die Beschichtung auf der Isolierstoffplatte hat vorzugsweise eine Dicke von 0,01 bis 10 mm, besonders bevorzugt von 0,1 bis 3 mm. In diesen Bereichen wird einerseits eine ausreichende Wärmekapazität der Schicht erzielt und andererseits das Verhältnis von Oberfläche zu Volumen noch hinreichend groß gehalten, um eine effiziente Abgabe der Wärme an die Umgebung zu ermöglichen.

Wie bereits oben erwähnt, ist es von Vorteil, wenn eine oder mehrere Bohrungen in der Leiterplatte ganz oder teilweise mit der Beschichtung ausgefüllt sind. Vorzugsweise befindet sich dabei in der Bohrung ein Metallkörper in Kontakt zur Beschichtung. Hierbei kann es sich um einen Metallstift oder eine Niete handeln, der/die etwa zentriert in der Bohrung sitzt und von der Masse umgeben wird. Vorzugsweise besteht der Metallkörper indes aus einer Beschichtung der Innenfläche der Bohrung. Eine derartige Kaschierung der Bohrung ist aus dem Stand der Technik bekannt und hat den Vorteil, daß insoweit existierende Produktionsverfahren nicht geändert werden müssen.

Vorzugsweise wird der genannte Metallkörper, der sich in die Bohrung erstreckt, außerhalb der Bohrung zu wärmeproduzierenden Bereichen bzw. Bauteilen auf der Leiterplatte fortgesetzt. Die sehr gute Wärmeleitfähigkeit des Metalls wird daher ausgenutzt, um die Wärme schnell und sicher von kritischen Stellen in weniger kritische Regionen abzuleiten und sie schließlich an die Wärmesenke abzugeben.

Die erfindungsgemäße Beschichtung der Leiterplatte kann so erfolgen, daß die resultierende Temperaturantwortfunktion des Systems mindestens der eines konventionellen Heatsinksystems entspricht. D.h., daß die erfindungsgemäße Beschichtungsmasse die Wärme mindestens genauso gut an die Umgebung ableitet, wie ein aus dem Stand der Technik bekanntes System. Dieses Verhalten kann durch die gezielte Auswahl von Parametern (z.B. Größe, Dicke, Wärmeleitfähigkeit etc.) der Beschichtungsmasse erzielt werden.

Die Beschichtung auf der beschriebenen Leiterplatte wird vorzugsweise mit einer erfindungsgemäßen Masse der oben beschriebenen Art hergestellt.

Zur Erfindung gehört ferner ein Verfahren zur Herstellung von Leiterplatten aus einer Isolierstoffplatte, wobei
a) auf der Isolierstoffplatte Leiter zur Verbindung von elektrischen Bauteilen aufgebracht werden,
b) ggf. in die Isolierstoffplatte Bohrungen und/oder Lande/Anschlußflächen zur Bestückung mit elektrischen Bauteilen eingebracht werden,
c) ggf. Teile der Oberfläche der Isolierstoffplatte zur Wärmeableitung mit einer Metallschicht beschichtet werden.

Dieses insoweit bekannte Verfahren wird erfindungsgemäß dadurch fortgesetzt, daß
d) die Oberfläche der Isolierstoffplatte ganz oder teilweise mit einer nicht-metallischen Masse mit einer Wärmeleitfähigkeit λ von mindestens 0,5 W/mK beschichtet wird.

Dabei können sich zwischen der Beschichtung und der Isolierstoffplatte evtl. noch weitere Materialschichten befinden, sofern es sich hierbei nicht ausschließlich um Metallschichten handelt.

Mit dem erfindungsgemäßen Verfahren werden die bereits oben erläuterten Vorteile erzielt, d.h., daß eine Beschichtung erzeugt wird, die unmittelbar als Wärmesenke auf der Leiterplatte dient. Ein aufwendiges Aufbringen von Metallfolien und deren anschließende elektrische Isolierung ist daher nicht notwendig.

Vorzugsweise wird im erfindungsgemäßen Teilschritt d) die Masse auf die Leiterplatte aufgedruckt, besonders bevorzugt im Siebdruck- und/oder Schablonendruckverfahren. Nach entsprechender Viskositätseinstellung können auch Tampon-Druck, Dispensen sowie selektive Beschichtungsverfahren, wie sie bei der Verarbeitung von conformal coatings (Schutzlacken) gebräuchlich sind (z.B. Nordson-Selectcoat®) angewendet werden. Druckverfahren erlauben eine schnelle, zeitsparende, kostensparende und gleichzeitig präzise maschinelle Verarbeitung. Einrichtungen zum Drucken sind in der Leiterplattenherstellung ohnehin vorhanden. Das erfindungsgemäße Verfahren erzielt damit eine erhebliche Vereinfachung gegenüber dem bekannten Stand der Technik zur Aufbringung von Wärmesenken.

Die Beschichtungsmasse kann insbesondere auch über metallische Flächen gedruckt werden, um von diesen Wärme abzuleiten. Damit können, wo es darauf ankommt, vorteilhafte Eigenschaften der Metalle weiterhin ausgenutzt werden.

Eine Aushärtung der Beschichtung erfolgt z.B. durch Erwärmung auf Temperaturen bis zu 180 °C und/oder durch Bestrahlung mit IR- oder UV-Licht und/oder durch Kontakt mit Luft bzw. Sauerstoff. Das hierbei bevorzugte Verfahren richtet sich nach den übrigen Randbedingungen, die durch die Leiterplatte, die Masse und den Beschichtungsprozeß vorgegeben sind.

Nach der Beschichtung und Aushärtung der Masse auf der Leiterplatte ist eine mechanische Bearbeitung, z.B. durch Bohren, Fräsen, Sägen, Stanzen, Ritzen usw. möglich.

Die Weiterverarbeitung der Leiterplatte erfolgt üblicherweise so, daß nach der Beschichtung mit der wärmeleitfähigen Masse im erfindungsgemäßen Teilschritt d) die elektrischen Bauteile aufgebracht und verlötet werden. Hierzu ist es erforderlich, daß die Beschichtung diese Weiterverarbeitung, d.h. insbesondere das Löten, aushält. Die Beschichtung muß daher entweder von den Lötstellen entfernt gehalten werden oder es wird vorzugsweise eine lötbeständige Masse verwendet.

Die genannten Anforderungen können insbesondere dann erfüllt werden, wenn eine erfindungsgemäße Masse der oben beschriebenen Art verwendet wird.

Im folgenden wird die Erfindung mit Hilfe von Figuren und anhand von Formulierungsbeispielen für den Lack näher erläutert.

Figur 1 zeigt einen Querschnitt durch eine Leiterplatte mit Wärmesenke nach dem Stand der Technik.

Figur 2 zeigt einen Querschnitt durch eine Leiterplatter mit der erfindungsgemäßen Beschichtung.

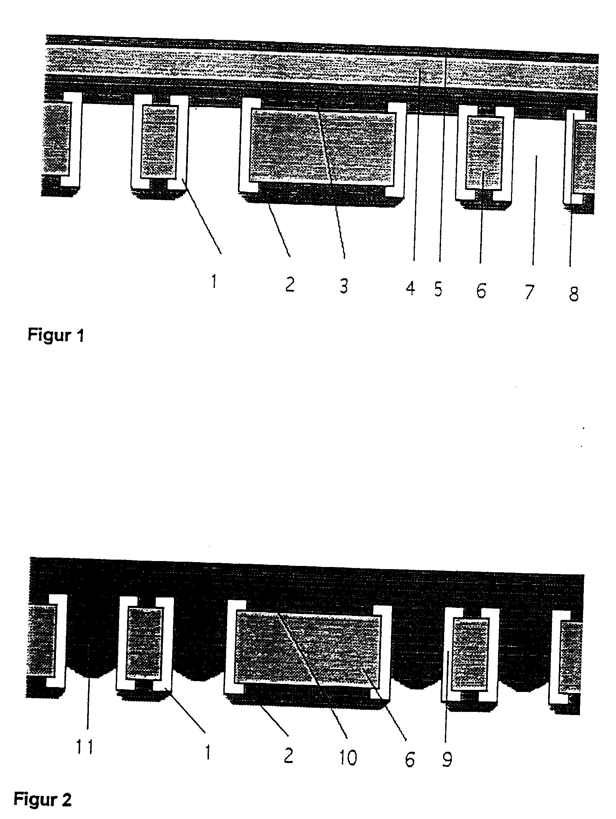

In Figur 1 ist ein Querschnitt durch eine Leiterplatte mit dem Leiterplattenkern 6 (Isolierstoffplatte) dargestellt, in welchem sich Bohrlöcher 7 zur Aufnahme der Bestückung bzw. zur Herstellung einer wärmeleitenden Verbindung von der Vorder- zur Rückseite der Leiterplatte befinden. Zur Verbesserung der Wärmeleitung durch die Wärmeleitbohrungen sind die Oberflächen dieser Bohrungen in Form einer Hülse 1 metallisiert.

Im übrigen befindet sich auf der Vorderseite der Leiterplatte (untere Seite in Figur 1) auf der Isolierstoffplatte eine Beschichtung mit Lötstopplack 2.

Auf der Rückseite der Leiterplatte (obere Seite in Figur 1) befindet sich großflächig die Wärmesenke 4, d.h. im Stand der Technik eine ausgestanzte Metallfolie. Diese Metallfolie 4 wird mittels einer Klebefolie 3 von Hand auf die Rückseite der Leiterplatte aufgeklebt. Dabei werden die Wärmeleitbohrungen 7 flach überdeckt, ohne daß Material in die Bohrung selbst eindringt. Ein Wärmeübergang findet nur an den relativ kleinen Kontaktflächen zwischen der Klebefolie 3 und den Teilen 8 der Hülse 1 statt, welche aus der Wärmeleitbohrung heraus sich auf die Rückseite der Leiterplatte erstrecken.

Um eine nachfolgende Bestückung auch der Rückseite der Leiterplatte zu ermöglichen, muß die Wärmesenke 4 nach außen hin mit einem Lötstopplack 5 überzogen werden. Sowohl dieser Lötstopplack 5 als auch die Klebefolie 3 wirken sich nachteilig auf den Wärmetransport und die Wärmeabgabe aus, da sie beide Hindernisse für den Wärmeübergang darstellen.

In Figur 2 ist eine Leiterplatte mit einer erfindungsgemäßen Beschichtung dargestellt. Wie beim Stand der Technik besteht die Leiterplatte zunächst aus einem Leiterplattenkern 6 (Isolierstoffplatte), aus Wärmeleitbohrungen mit metallisierten Oberflächen (Hülse 1), sowie weiteren üblichen Ausstattungen wie z.B. der Beschichtung mit einem Lötstopplack 2 auf der Vorderseite der Leiterplatte (untere Seite in Figur 2).

Im Gegensatz zum Stand der Technik befindet sich jedoch nicht ein mehrschichtiger Aufbau aus einer Klebefolie, einer Metallfolie und einer Lötstopplack-Beschichtung auf der Rückseite der Leiterplatte, sondern diese Rückseite ist ausschließlich mit der erfindungsgemäßen Beschichtungsmasse 10 beschichtet. Dies hat eine Reihe erheblicher Vorteile:

Erstens ist eine Aufbringung dieser Schicht vereinfacht und maschinell möglich, insbesondere durch ein Siebdruck- oder Schablonendruckverfahren. Zweitens erhält man eine homogene Wärmesenke, welche nicht durch Schichtgrenzen zu einer Klebefolie oder zu einer Lötstopplack-Beschichtung im Wärmetransport behindert ist. Drittens dringt die Beschichtungsmasse 10 in Form von Fingern 11 in die Wärmeleitbohrungen ein und hat damit sowohl eine erheblich größere Kontaktfläche für den Wärmeübergang von den Hülsen 1 als auch eine aktive Beteiligung am Wärmetransport von der Vorderseite der Leiterplatte durch diese hindurch zur Rückseite.

Die erfindungsgemäße Beschichtungsmasse hat hervorragende Hafteigenschaften auf verschiedensten Untergründen, ist lötbeständig, selbstverlöschend und temperaturbeständig. Ein aufwendiger mehrschichtiger Aufbau der Wärmesenke erübrigt sich damit, und man erhält gleichzeitig verbesserte Wärmetransporteigenschaften.

### Beispiele

### 1. Rezeptur: 1-Komponenten-System, lösemittelfrei

Herstellung einer Mischung aus
- 30 - 34: Teilen einer Mischung eines modifizierten flüssigen Bisphenol-A/F-Harzes mit einem Epoxidwert von 0,48 - 0,58
- 0,3 - 0,6: Teilen eines Netzmittels auf des Basis eines Alkylammoniumsalzes einer Polycarbonsäure
- 33 - 37: Teilen eines chemisch inerten, gut wärmeleitenden Pigments/Füllstoffes einer gegebenen mittleren Korngröße von ca. 8 bis 12 µm
- 20 - 22: Teilen eines chemisch inerten, gut wärmeleitenden Pigments/Füllstoffes einer gegebenen mittleren Korngröße von ca. 15 bis 20 µm
- 5 - 7: Teilen eines speziell formulierten Cyanoguanidins
- 0,5 - 2: Teilen eines Reaktionsbeschleunigers auf Basis eines substituierten Carbonyldiamids
- 2 - 4: Teilen eines farbgebenden, chemisch inerten und temperaturbeständigen Pigments/Farbstoffes.

Diese Mischung ist verdruckbar und z. B. in 30 Minuten bei einer Temperatur von 150°C auszuhärten.

### 2. Rezeptur: 2-Komponenten-System, lösemittelfrei

Herstellung einer Mischung aus:

### Komponente A1

- 43 - 45: Teilen einer Mischung eines flüssigen modifizierten Bisphenol-A/F-Harzes mit einem Epoxidwert von 0,48 - 0,58
- 1,5 - 3,0: Teilen eines chemisch inerten Thixotropie- und Antiabsetzmittels
- 33 - 37: Teilen eines chemisch inerten, gut wärmeleitenden Pigments/Füllstoffes einer gegebenen mittleren Korngröße von ca. 8 bis 12 µm
- 10 - 12: Teilen eines chemisch inerten, gut wärmeleitenden Pigments/Füllstoffes einer gegebenen mittleren Korngröße von ca. 15 bis 20 µm
- 1 - 3: Teilen eines Netzmittels auf des Basis eines Alkylammoniumsalzes einer Polycarbonsäure
- 2 - 4: Teilen eines farbgebenden, chemisch inerten und temperaturbeständigen Pigments/Farbstoffes

### Komponente B1

- 35 - 37: Teilen eines modifizierten Polyaminoamids mit einem H-Aktiv-Äquivalent-gewicht von 95 - 120
- 0,5 - 1,5: Teilen eines chemisch inerten Thixotropie- und Antiabsetzmittels
- 49 - 52: Teilen eines chemisch inerten, gut wärmeleitenden Pigments/Füllstoffes einer gegebenen mittleren Korngröße von ca. 15 bis 20 µm
- 10 - 12: Teilen eines chemisch inerten, gut wärmeleitenden Pigments/Füllstoffes einer gegebenen mittleren Korngröße von ca. 8 bis 12 µm
- 0,5 - 1,3: Teilen eines Verlaufs- und Antikratermittels auf des Basis eines Acrylpolymers

### Komponente B2

- 39 - 42: Teilen eines modifizierten cycloaliphatischen Säureanhydrids mit einem H-Aktiv-Äquivalentgewicht von 170 - 200
- 1,5 - 3,5: Teilen eines chemisch inerten Thixotropie- und Antiabsetzmittels
- 1,5 - 3,0: Teile eines Reaktionsbeschleunigers auf Basis eines tertiären Amins
- 53 - 57: Teilen eines chemisch inerten, gut wärmeleitenden Pigments/Füllstoffes einer gegebenen mittleren Korngröße von ca. 8 bis 12 µm
- 0,5 - 1,3: Teilen eines Verlaufs- und Antikratermittels auf des Basis eines Acrylpolymers

Die Stammkomponente A1 wird im Verhältnis 1 zu 1 mit der Härterkomponente B1 oder der Härterkomponente B2 gemischt und ergibt eine verdruckbare Mischung. Die beiden Härter-Komponenten werden gewählt, um unterschiedliche Aushärtungstemperaturen zu ermöglichen; resultierend sind auch unterschiedliche mechanische Eigenschaften.

### Komponente A2

- 43 - 45: Teilen einer Mischung eines flüssigen modifizierten Bisphenol-A/F-Harzes mit einem Epoxidwert von 0,48 - 0,58
- 1,5 - 3,0: Teilen eines chemisch inerten Thixotropie- und Antiabsetzmittels
- 38 - 42: Teilen eines chemisch inerten, gut wärmeleitenden Pigments/Füllstoffes einer gegebenen mittleren Korngröße von ca. 8 bis 12 µm
- 7 - 10: Teilen eines chemisch inerten, gut wärmeleitenden Pigments/Füllstoffes einer gegebenen mittleren Korngröße von ca. 15 bis 20 µm
- 2 - 7: Teilen eines chemisch inerten, gut wärmeleitenden Pigments/Füllstoffes einer gegebenen mittleren Korngröße von 10 bis 60 µm
- 1 - 3: Teilen eines Netzmittels auf des Basis eines Alkylammoniumsalzes einer Polycarbonsäure
- 2 - 4: Teilen eines farbgebenden, chemisch inerten und temperaturbeständigen Pigments/Farbstoffes

### Komponente A3

- 43 - 45: Teilen einer modifizierten Mischung eines flüssigen Bisphenol-A/F-Harzes mit einem Epoxidwert von 0,48 - 0,58
- 1,5 - 3,0: Teilen eines chemisch inerten Thixotropie- und Antiabsetzmittels
- 42 - 45: Teilen eines chemisch inerten, gut wärmeleitenden Pigments/Füllstoffes einer gegebenen mittleren Korngröße von ca.8 bis 12 µm
- 10 - 12: Teilen eines oberflächenbehandelten, schuppenförmigen und gut wärmeleitenden Pigments/Füllstoffes
- 2 - 4: Teilen eines farbgebenden, chemisch inerten und temperaturbeständigen Pigments/Füllstoffes

Die Komponente A2 und A3 können im Verhältnis 1 zu 1 mit der Härterkomponente B1 oder der Härterkomponente B2 zu einer druckfähigen Masse gemischt werden. Diese Mischungen zeichnen sich durch erhöhte Wärmeleitfähigkeiten gegenüber den vorgenannten Mischungen aus.

### Komponente A4

- 47 - 52: Teilen einer modifizierten Mischung eines flüssigen Bisphenol-A/F-Harzes mit einem Epoxidwert von 0,48 - 0,58
- 1,5 - 3,0: Teilen eines chemisch inerten Thixotropie- und Antiabsetzmittels
- 19 - 24: Teilen eines chemisch inerten, gut wärmeleitenden Pigments/Füllstoffes einer gegebenen mittleren Korngröße von ca. 3 - 5 µm
- 19 - 24: Teilen eines chemisch inerten, gut wärmeleitenden Pigments/Füllstoffes einer gegebenen mittleren Korngröße von ca. 28 - 33 µm
- 9 - 12: Teilen eines chemisch inerten, gut wärmeleitenden Pigments/Füllstoffes einer gegebenen mittleren Korngröße von ca. 14 - 150 µm
- 2 - 4: Teilen eines farbgebenden, chemisch inerten und temperaturbeständigen Pigments/Farbstoffes

### Komponente B4

- 49 - 52: Teilen eines modifizierten aliphatischen Polyamins mit einem H-Aktiv-Äquivalentgewicht von 40 - 50
- 1,5 - 3,5: Teilen eines chemisch inerten Thixotropie- und Antiabsetzmittels
- 40 - 44: Teilen eines chemisch inerten, gut wärmeleitenden Pigments/Füllstoffes einer gegebenen mittleren Korngröße von ca. 3 - 5 µm
- 20 - 24: Teilen eines chemisch inerten, gut wärmeleitenden Pigments/Füllstoffes einer gegebenen mittleren Korngröße von ca. 28 - 33 µm
- 0,5 - 1,3: Teilen eines Verlaufs- und Antikratermittels auf des Basis eines Acrylpolymers

Die Komponenten A4 und B4 werden im Verhälnis 2 zu 1 gemischt und sind in hohen Schichten verdruckbar.

Trocknungsparameter sind z. B. ca. 60 Minuten bei einer Temperatur von 80 °C bzw. ca. 40 Minuten bei 150 °C.

### 3. Rezeptur: physikalisch trocknendes Hochpolymer

Herstellung einer Mischung aus:
- 10 - 13: Teile eines Chlorkautschukpulvers
- 8 - 13: Teile eines Polyvinylchloridpulvers
- 0,5 - 1,5: Teile eines epoxidmodifizierten Kunstharzes
- 1 - 4: Teile organischen Derivates eines Montmorillonits
- 13 - 16: Teile eines aromatischen Lösemittels mit einem Siedebereich von 230 - 250 °C
- 30 - 34: Teile eines chemisch inerten, gut wärmeleitenden Pigments/Füllstoffes einer gegebenen mittleren Korngröße von ca. 8 bis 12 µm
- 8 - 12: Teile eines chemisch inerten, gut wärmeleitenden Pigments/Füllstoffes einer gegebenen mittleren Korngröße von ca. 15 bis 20 µm
- 7 -10: Teile eines chemisch inerten, gut wärmeleitenden Pigments/Füllstoffes einer gegebenen mittleren Korngröße von ca. 10 bis 60 µm
- 0,5 - 1,5: Teile eines Stabilisators auf Basis organischer Metallverbindungen
- 2 - 5: Teile eines speziellen Kunstharzes
- 2 - 5: Teile eines aromatischen Lösemittels mit einem Siedebereich von 180-210°C
- 4 - 7: Teile eines aromatischen Lösemittels mit einem Siedebereich von 230 -250°C
- 0,1 - 0,5: Teile eines Entlüftungs- und Entschäumungsmittels
- 2 - 4: Teile eines farbgebenden, chemisch inerten und temperaturbeständigen Pigments/Farbstoffes.

### 4. Rezeptur: 2-Komponenten-System, lösemittelhaltig

Herstellung einer Mischung aus:

### Komponente A

- 33 - 36: Teilen einer Mischung eines flüssigen modifizierten Bisphenol-A/F-Harzes mit einem Epoxidwert von 0,48 - 0,58
- 2,0 - 4,0: Teilen eines chemisch inerten Thixotropie- und Antiabsetzmittels
- 33 - 37: Teilen eines chemisch inerten, gut wärmeleitenden Pigments/Füllstoffes einer gegebenen mittleren Korngröße von ca. 8 bis 12 µm
- 10 - 12: Teilen eines chemisch inerten, gut wärmeleitenden Pigments/Füllstoffes einer gegebenen mittleren Korngröße von ca. 15 bis 20 µm
- 1 - 3: Teilen eines Netzmittels auf des Basis eines Alkylammoniumsalzes einer Polycarbonsäure
- 2 - 4: Teilen eines farbgebenden, chemisch inerten und temperaturbeständigen Pigments/Farbstoffes
- 7 - 9: Teilen eines aromatischen Lösemittels mit einem Siedebereich von 230 - 250°C

### Komponente B

- 28 - 31: Teilen eines modifizierten Polyaminoamids mit einem H-Aktiv-Äquivalent-gewicht von 95 - 120
- 2,0 - 4,0: Teilen eines chemisch inerten Thixotropie- und Antiabsetzmittels
- 49 - 52: Teilen eines chemisch inerten, gut wärmeleitenden Pigments/Füllstoffes einer gegebenen mittleren Korngröße von ca. 15 bis 20 µm
- 10 - 12: Teilen eines chemisch inerten, gut wärmeleitenden Pigments/Füllstoffes einer gegebenen mittleren Korngröße von ca. 8 bis 12 µm
- 0,5 - 1,3: Teilen eines Verlaufs- und Antikratermittels auf des Basis eines Acrylpolymers
- 6 - 8: Teilen eines aromatischen Lösemittels mit einem Siedebereich von 230 - 250°C

Die Stammkomponente A wird im Verhältnis 1 zu 1 mit der Härterkomponente B gemischt und ergibt eine verdruckbare Mischung, die z.B. 60 Minuten bei einer Temperatur von 80°C getrocknet werden kann.

Je nach Wahl der Pigmentierung kann es für die Nichtbrennbarkeitsstufe VO nach UL 94 erforderlich sein, 3 - 6 Teile des Bindemittels durch flammhemmende Polymere auf Basis von speziell formulierten Halogenverbindungen oder solchen auf Basis von Phosphorsäureestern zu ersetzen.

### 5. Rezeptur 2-Komponenten-System, lösemittelfrei

Gelöst wird diese Aufgabe durch Herstellung einer Mischung aus:

### Komponente A5

1.5 - 3,0 Teilen eines chemisch inerten Thixotropie - und Antiabsetzmittels auf Basis pyrogener Kieselsäure
33 - 37 Teilen eines Füllstoffes auf Basis von Aluminiumnitrid
10 - 12 Teilen eines Füllstoffes auf Basis von Aluminiumoxid
1 - 3 Teilen eines Netzmittels auf der Basis eines Alkylammoniumsalzes einer Polycarbonsäure
2 - 4 Teilen eines Pigments auf Basis eines Eisenoxides

### Komponente B5

35 - 37 Teilen eines modifizierten Polyaminoamids mit einem H-Aktiv-Äquivalentgewicht von 95-120
0,5 - 1,5 Teilen eines chemisch inerten Thixotropie- und Antiabsetzmittels auf Basis pyrogener Kieselsäure
49 - 52 Teilen eines Füllstoffes auf Basis von Aluminiumnitrid
10 - 12 Teilen eines Füllstoffes auf Basis von Aluminiumoxid
0,5 - 1,3 Teilen eines Verlaufs-und Antikratermittels auf der Basis eines Acrylpolymers

Die erfindungsgemäßen Beschichtungssysteme haben typischerweise folgende Kennzahlen und Eigenschaften:

### 1. Kennzahlen

| **Kriterium** | **Prüfmethode** | **1-K- System** | **2-K- System** |
|---|---|---|---|
| **Farbe** | **-** | z. B. Schwarz | z. B. Schwarz |
| **Viskosität** | bei 20°C gemäß DIN EN ISO 3219 | | |
| Komponente A [mPas] | | - | ca. 25.000 |
| Komponente B [mPas] | | - | ca. 46.000 |
| Mischung [mPas] | | ca. 41.000 | ca. 35.000 |
| **Festkörpergehalt** [Gew.-%] | DIN 53 216, Teil 1 (1h/125°C, 1g Einwaage) | bis 100 | bis 100 |
| **Dichte** | bei 20°C, DIN 53 217, Teil 2 | | |
| Komponente A [g/cm³] | | - | 1,7 |
| Komponente B [g/cm³] | | - | 2,0 |
| Mischung [g/cm³] | | 1,9 | 1,8 |
| **Topfzeit** [h] | bei Raumtemperatur ca. 18-23°C; Ansatzgröße 500g | - | 8 |
| **Haltbarkeit** [Monate] | | 9 | 12 |

### 2. Eigenschaften (physikalische, mechanische und elektrische Eigenschaften)

| **Kriterium** | **Prüfmethode** | **1-K- System** | **2-K- System** |
|---|---|---|---|
| **Lötbadbeständigkeit** [s/°C] | IPC-SM-840 C, 4.8.9.2 | erfüllt (20/265) | erfüllt (20/265) |
| | MIL P 55 110 C | erfüllt (10/288) | erfüllt (10/288) |
| **Lösungsmittelbeständigkeit** | IPC-SM-840 C, 3.6.1.1 Isopropanol | erfüllt | erfüllt |
| | Isopropanol (75%) / H₂O (25%) | erfüllt | erfüllt |
| | Monoethanolamin | erfüllt | erfüllt |
| | deionisiertes H₂O | erfüllt | erfüllt |
| **Oberflächenwiderstand** [Ohm] | VDE 0303, Teil 3 | ca. 10¹⁴ -10¹⁶ | ca. 10¹⁴ -10¹⁶ |
| **Durchgangswiderstand** [Ohm x cm] | VDE 0303, Teil 3 | ca. 10¹⁴ -10¹⁶ | ca. 10¹⁴ -10¹⁶ |
| **Feuchtigkeitsbeständigkeit und Isolationswiderstand** | IPC-SM-840 C, 3.9.1 | erfüllt Anforderungen der Klassen H und T | erfüllt Anforderungen der Klassen H und T |
| **Kriechstromfestigkeit** | IEC 112, in Verbindung mit VDE 0109, Teil 11 auf Basismaterial mit CTI 250 | > 350 | > 350 |
| **Durchschlagfestigkeit** [kV/mm] | VDE 0303, Teil 2 | > 10 | > 10 |
| **Isolierstoffklasse** [°C] | VDE 0530, Teil 1 | F = 155* | F = 155* |
| **Wärmekapazität** [J/gK] | gemessen mit Kalorimeter | ca. 1 | ca. 1 |
| **Wärmeleitfähigkeit** [W/mK] | in Anlehnung an VDE 0304, Teil 1 | ca. 1 | ca. 1 |

| | | | |
|---|---|---|---|
| *F = 155°C = Grenztemperatur | | | |

## Patentansprüche

1. Bindemittel enthaltende Masse, insbesondere geeignet für die Beschichtung von Leiterplatten, wobei die ausgehärtete Masse eine Wärmeleitfähigkeit λ von mindestens 0,5 W/mK hat, **dadurch gekennzeichnet,** daß die Masse vor dem Aushärten eine dynamische Viskosität η von mindestens 10 Pas hat.

2. Masse nach Anspruch 1,
**dadurch gekennzeichnet,** daß sie insbesondere durch Einstellung der Viskosität vor dem Aushärten geeignet ist für Siebdruck, Schablonendruck, Tampon-Druck, Dispensen und/oder selektive Beschichtungsverfahren.

3. Masse nach einem der Ansprüche 1 oder 2, **dadurch gekennzeichnet,** daß nach der Application der Masse eine lunkerfreie Beschichtung erzielbar ist.

4. Masse nach einem der vorhergehenden Ansprüche, **dadurch gekennzeichnet,** daß entsprechend der gewählten Application wärmeerzeugende Komponenten komplett oder partiell umhüllbar sind.

5. Masse nach einem der vorhergehenden Anspüche, **dadurch gekennzeichnet,** daß Kühlkörper auf einer Leiterplatte mechanisch fixierbar und thermisch anbindbar sind.

6. Masse nach einem der Ansprüche 1 bis 5,
**dadurch gekennzeichnet,** daß sie lötbadbeständig ist.

7. Masse nach Anspruch 6,
**dadurch gekennzeichnet,** daß keine Lotanhaftungen ihr verbleiben und eine ausreichende Haftung zum Substrat verbleibt.

8. Masse nach einem der Ansprüche 1 bis 7,
**dadurch gekennzeichnet,** daß die ausgehärtete Masse selbstverlöschend ist.

9. Masse nach einem der Ansprüche 1 bis 8,
**dadurch gekennzeichnet,** daß die ausgehärtete Masse einen Oberflächenwiderstand von ca. 10¹⁴ bis 10¹⁶ Ω, einen Durchgangswiderstand von ca. 10¹⁴ bis 10¹⁶ Ω cm, eine Durchschlagfestigkeit von mehr als 10 kV/mm und/oder eine Kriechstromfestigkeit von mehr als 350 aufweist.

10. Masse nach einem der Ansprüche 1 bis 9,
**dadurch gekennzeichnet,** daß die ausgehärtete Masse dauerbeständig bei Temperaturen von über 100°C, vorzugsweise über 150°C, ist.

11. Masse nach einem der vorhergehenden Ansprüche,
**dadurch gekennzeichnet,** daß nach der Aushärtung, vorzugsweise bei großflächiger Application, die Neigung zur Verwindung und Verwölbung der Leiterplatte minimiert ist.

12. Masse nach einem der Ansprüche 1 bis 11,
**dadurch gekennzeichnet,** daß das Bindemittel eine Naturharz-, Epoxy-, Chlorkautschuk-, Polyester-, Polyacryl-, Aminoharz-, Phenolharz-, Polyvinyl-, Silikon-, Silikonkautschuk-, Polyurethan- oder Polyharnstoffsystem und/oder ein acrylgruppenhaltiges UV-härtendes System und/oder ein anorganisches Bindemittelsystem, insbesondere Silicat, oder ein Gemisch von mindestens zwei der vorgenannten Systeme ist.

13. Masse nach einem der Ansprüche 1 bis 12,
**dadurch gekennzeichnet,** daß sie aus einer Harzmatrix mit einer oder mehreren feinverteilten Substanzen, vorzugsweise in Form von Feststoffpartikeln, einer Wärmeleitfähigkeit λ von mindestens 0,5 W/mK besteht.

14. Masse nach Anspruch 13,
**dadurch gekennzeichnet,** daß die feinverteilten Feststoffpartikel eine Teilchengrößenverteilung mit mindestens zwei Maxima besitzen

15. Masse nach Anspruch 13 oder 14,
**dadurch gekennzeichnet,** daß die feinverteilten Feststoffpartikel unterschiedliche Teilchenformen besitzen, vorzugsweise in etwa sphärische Teilchen kombiniert mit dendritischen und/oder faserförmigen und/oder lamellaren Teilchen.

16. Masse nach einem der Ansprüche 13 bis 15,
**dadurch gekennzeichnet,** daß die Feststoffpartikel eine Größe von 1 µm bis 150 µm haben.

17. Masse nach einem der Ansprüche 13 bis 16,
**dadurch gekennzeichnet,** daß die Feststoffpartikel ganz oder teilweise aus Metallen, vorzugsweise Kupfer, Aluminium, Zink, Eisen und/oder Metalloxiden und/oder eutektischen Mischungen und/oder Legierungen bestehen, wobei die Metalloxide vorzugsweise als Überzug auf einem Metallkern angeordnet sind.

18. Masse nach einem der Ansprüche 13 bis 17,
**dadurch gekennzeichnet,** daß die Feststoffpartikel ganz oder teilweise bestehen
a) aus Keramik, vorzugsweise aus Nitriden, Karbiden, Boriden, Siliciden oder Silicaten, und/oder
b) aus Polymeren, vorzugsweise aus faserförmigen Polyaromaten, und/oder
c) aus natürlichen oder synthetischen Mineralien, vorzugsweise Bariumsulfaten, Magnesium- und/oder Aluminiumsilikaten.

19. Masse nach einem der Ansprüche 1 bis 18,
**dadurch gekennzeichnet,** daß sie Lösemittel und/oder Formulierungshilfsstoffe und/oder Pigmente und/oder Füllstoffe enthält.

20. Masse nach einem der Ansprüche 1 bis 19,
**dadurch gekennzeichnet,** daß sie
10 - 40 Gewichtsteile Bindemittel
20 - 80 Gewichtsteile wärmeleitende Feststoffe und ggf. farbgebende - vorzugsweise anorganische oder organische, lösliche oder schwer lösliche - Substanzen, und/oder Füllstoffe,
0 - 30 Gewichtsteile Formulierungshilfsstoffe und/oder Lösemittel.
enthält.

21. Masse nach einem der Ansprüche 1 bis 20,
**dadurch gekennzeichnet,** daß er als 1-Komponenten oder 2-Komponenten System hergestellt wird.

22. Leiterplatte mit einer Isolierstoffplatte sowie Leitern und/oder Bohrungen zur Bestückung mit elektronischen Bauteilen, **dadurch gekennzeichnet,** daß zumindest auf Teilen der Oberfläche der Isolierstoffplatte und/oder in mindestens einer Bohrung der Leiterplatte eine nicht-metallische Beschichtungsmasse mit einer Wärmeleitfähigkeit λ von mindestens 0,5 W/mK angeordnet ist.

23. Leiterplatte nach Anspruch 22,
**dadurch gekennzeichnet,** daß zwischen einer Teilfläche der Beschichtungsmasse und der Isolierstoffplatte mindestens eine Metallschicht angeordnet ist.

24. Leiterplatte nach einem der Ansprüche 22 oder 23,
**dadurch gekennzeichnet,** daß die Beschichtungsmasse eine Dicke von 0,01 bis 10 mm, vorzugsweise 0,1 bis 3 mm, hat.

25. Leiterplatte nach einem der Ansprüche 22 bis 24,
**dadurch gekennzeichnet,** daß eine oder mehrere Bohrungen in der Leiterplatte mit der Beschichtungsmasse ganz oder teilweise ausgefüllt sind.

26. Leiterplatte nach Anspruch 25,
**dadurch gekennzeichnet,** daß in der Bohrung ein Metallkörper in Kontakt zur Masse angeordnet ist, wobei der Metallkörper vorzugsweise in Form einer Beschichtung der Innenfläche der Bohrung vorliegt.

27. Leiterplatte nach Anspruch 26,
**dadurch gekennzeichnet,** daß der Metallkörper außerhalb der Bohrung zu wärmeproduzierenden Bereichen auf der Leiterplatte fortgeführt ist.

28. Leiterplatte nach einem der Ansprüche 22 bis 27,
**dadurch gekennzeichnet,** daß die Temperaturantwortfunktion mindestens der eines konventionellen Heatsinksystems entspricht.

29. Leiterplatte nach einem der Ansprüche 22 bis 28,
**dadurch gekennzeichnet,** daß die Beschichtungsmasse aus einer Masse nach einem der Ansprüche 1 bis 21 besteht.

30. Verfahren zur Herstellung von Leiterplatten aus einer Isolierstoffplatte, wobei
a) auf der Isolierstoffplatte Leiter zur Verbindung von elektrischen Bauteilen aufgebracht werden,
b) ggf. in der Isolierstoffplatte Bohrungen und/oder Lande-/Anschlußflächen zur Bestückung mit elektrischen Bauteilen eingebracht werden,
c) ggf. Teile der Oberfläche der Isolierstoffplatte zur Wärmeableitung mit einer Metalischicht beschichtet werden,
**dadurch gekennzeichnet,** daß
d) die Oberfläche der Isolierstoffplatte ganz oder teilweise mit einer nicht-metallischen Masse mit einer Wärmeleitfähigkeit λ von mindestens 0,5 W/mK beschichtet wird.

31. Verfahren nach Anspruch 30,
**dadurch gekennzeichnet,** daß die Masse aufgedruckt wird, vorzugsweise mittels Siebdruck, Schablonendruck, Tampon-Druck, Dispensen und/oder selektiver Beschichtungsverfahren.

32. Verfahren nach einem der Ansprüche 30 oder 31,
**dadurch gekennzeichnet,** daß die Masse zusätzlich auf metallische Flächen zur Wärmeableitung gedruckt wird.

33. Verfahren nach einem der Ansprüche 30 bis 32,
**dadurch gekennzeichnet,** daß die Masse durch Erwärmung auf Temperaturen bis 180°C und/oder Bestrahlung mit IR- oder UV-Licht und/oder Kontakt mit Luft bzw. Sauerstoff ausgehärtet wird.

34. Verfahren nach einem der vorhergehenden Ansprüche,
**dadurch gekennzeichnet,** daß nach der Beschichtung und Aushärtung der Masse auf der Leiterplatte eine mechanische Bearbeitung durchführbar ist, z.B. durch Bohren, Fräsen, Sägen, Stanzen, Ritzen und dgl.

35. Verfahren nach einem der Ansprüche 30 bis 34,
**dadurch gekennzeichnet,** daß nach der Beschichtung der Leiterplatte mit der Masse die elektrischen Bauteile aufgebracht und verlötet werden.

36. Verfahren nach einem der Ansprüche 30 bis 35,
**dadurch gekennzeichnet,** daß eine Masse nach einem der Ansprüche 1 bis 17 für die Beschichtung in Teilschritt d) verwendet wird.
